# EUROPEAN PATENT APPLICATION

(11) **EP 4 726 774 A1**
(43) Date of publication of application: **15.04.2026**
(21) Application number: 24206399.8
(22) Date of filing: 14.10.2024
(51) Int. Cl.: H01L 23/495

(54) **VERTICAL MULTI-TRANSISTOR DEVICE**

(71) Applicant: Infineon Technologies Austria AG, 9500 Villach (AT)
(72) Inventor: YUFEREV, Sergey, 9500 Villach (AT); PAOLUCCI, Milko, 9520 Sattendorf (AT)
(74) Representative: Lambsdorff & Lange Patentanwälte Partnerschaft mbB

(57) **Abstract**

A semiconductor package comprises a first transistor chip having a first side and a second side opposite the first side. The first side comprises at least one source chip pad, S1, and at least one drain chip pad, D1. The semiconductor package further comprises a second transistor chip having a first side and a second side opposite the first side, wherein the first side comprises at least one source chip pad, S2, and at least one drain chip pad, D2. A chip carrier has a first main side and a second main side opposite the first main side, wherein the first main side of the chip carrier faces the first side of the first transistor chip and is attached to the at least one source chip pad, S1, and the at least one drain chip pad, D1, of the first transistor chip, and the second main side of the chip carrier faces the first side of the second transistor chip and is attached to the at least one source chip pad, S2, and the at least one drain chip pad, D2, of the second transistor chip. The chip carrier is configured to electrically connect the first transistor chip and the second transistor chip serially in a D1-S1-D2-S2 configuration or in a S1-D1-D2-S2 configuration or in a D1-S1-S2-D2 configuration. In addition, chip carrier is configured to be attached to an application board in inclined, in particular vertical orientation relative to the application board.

## Description

### Technical Field

This disclosure relates generally to the technique of semiconductor packaging, and in particular to a multi-transistor chip package.

### Background

Packaging techniques can have a high impact on device performance. Packaging concepts may aim to provide a high routing capability, a high variability of footprint design, a good board level reliability (e.g., high thermal cycling on board (TCoB) performance) and good thermal dissipation into the board as well as low assembly cost. Moreover, in particular for power applications, the packaging concept should provide for miniaturization (reduction of the footprint area), electrical efficiency and low R_{DS(on)} (reduction of conduction losses and other losses), thermal efficiency, reduction of package parasitics, electromagnetic interference (EMI) safety (i.e., low radiated emissions), for example. In particular, an increase of power density of power semiconductor packages within the same area consumption (i.e., the space on an application board needed to mount the semiconductor package thereon) is desired.

Special package concepts are needed for lateral transistor chips such as, e.g., GaN chips. Some package concepts rely on laminate-based package solutions. By doing so, the footprint design of the device is no longer limited by the pad layout of the chip. However, the usage of laminate in packaging leads to higher package cost and limitations in terms of solder materials which can be used. Further, due to the relatively low metal thickness of the redistribution layer in the laminate, low package resistances are difficult to obtain. Therefore, lateral transistor chip packaging concepts employing leadframe (LF) technology have been proposed to overcome some of the above drawbacks.

### Summary

According to an aspect of the disclosure, a semiconductor package comprises a first transistor chip having a first side and a second side opposite the first side. The first side comprises at least one source chip pad, S1, and at least one drain chip pad, D1. The semiconductor package further comprises a second transistor chip having a first side and a second side opposite the first side, wherein the first side comprises at least one source chip pad, S2, and at least one drain chip pad, D2. A chip carrier has a first main side and a second main side opposite the first main side, wherein the first main side of the chip carrier faces the first side of the first transistor chip and is attached to the at least one source chip pad, S1, and the at least one drain chip pad, D1, of the first transistor chip, and the second main side of the chip carrier faces the first side of the second transistor chip and is attached to the at least one source chip pad, S2, and the at least one drain chip pad, D2, of the second transistor chip. The chip carrier is configured to electrically connect the first transistor chip and the second transistor chip serially in a D1-S1-D2-S2 configuration or in a S1-D1-D2-S2 configuration or in a D1-S1-S2-D2 configuration. In addition, chip carrier is configured to be attached to an application board in inclined, in particular vertical orientation relative to the application board.

### Brief description of the drawings

In the drawings, like reference numerals designate corresponding similar parts. The features of the various illustrated embodiments can be combined unless they exclude each other and/or can be selectively omitted if not described to be necessarily required. Embodiments are depicted in the drawings and are exemplarily detailed in the description which follows.
Figure 1 schematically illustrates a semiconductor package and a circuit diagram showing a first example of a series connection of two transistor chips of the semiconductor package.
Figure 2 schematically illustrates a semiconductor package and a circuit diagram showing a second example of a series connection of two transistor chips of the semiconductor package.
Figure 3 schematically illustrates a semiconductor package and a circuit diagram showing a third example of a series connection of two transistor chips of the semiconductor package.
Figure 4A is a perspective bottom view of an example of a transistor chip mounted on a leadframe.
Figure 4B schematically illustrates combining two leadframes to form a dual-side transistor chip package.
Figure 5A is a side perspective view of a first example of a dual-side transistor chip package.
Figure 5B is a bottom perspective view of the first example of a dual-side transistor chip package.
Figure 5C are side views from viewing directions V1 and V2 of the first example of a dual-side transistor chip package.
Figure 5D is a bottom view (footprint) of the first example of a dual-side transistor chip package.
Figure 6A is a plan view from direction V3 (see Figure 5A) on the first example of a dual-side transistor chip package in transparent contour illustration, wherein the VSW domain is highlighted by hatching.
Figure 6B is a plan view from direction V3 (see Figure 5A) on the first example of a dual-side transistor chip package in transparent contour illustration, wherein the VIN and GND domains are highlighted by hatching.
Figure 6C is a plan view from direction V3 (see Figure 5A) on the first example of a dual-side transistor chip package in transparent contour illustration, wherein the G1 and G2 domains are highlighted by hatching.
Figure 7A is a side perspective view of a second example of a dual-side transistor chip package.
Figure 7B is a bottom perspective view of the second example of a dual-side transistor chip package.
Figure 7C are side views from viewing directions V1 and V2 (see Figure 7A) of the second example of a dual-side transistor chip package.
Figure 7D is a bottom view (footprint) of the second example of a dual-side transistor chip package.
Figure 8A is a plan view from direction V3 (see Figure 7A) on the second example of a dual-side transistor chip package in transparent contour illustration, wherein the VSW domain is highlighted by hatching.
Figure 8B is a plan view from direction V3 (see Figure 7A) on the second example of a dual-side transistor chip package in transparent contour illustration, wherein the VIN and GND domains are highlighted by hatching.
Figure 8C is a plan view from direction V3 (see Figure 7A) on the second example of a dual-side transistor chip package in transparent contour illustration, wherein the G1 and G2 domains are highlighted by hatching.
Figure 9A is a side perspective view of a third example of a dual-side transistor chip package.
Figure 9B is a bottom perspective view of the third example of a dual-side transistor chip package.
Figure 9C are side views from viewing directions V1 and V2 (see Figure 9A) of the third example of a dual-side transistor chip package.
Figure 9D is a bottom view (footprint) of the third example of a dual-side transistor chip package.
Figure 10A is a plan view from direction V3 (see Figure 9A) on the third example of a dual-side transistor chip package in transparent contour illustration, wherein the VSW domain is highlighted by hatching.
Figure 10B is a plan view from direction V3 (see Figure 9A) on the third example of a dual-side transistor chip package in transparent contour illustration, wherein the VIN and GND domains are highlighted by hatching.
Figure 10C is a plan view from direction V3 (see Figure 9A) on the third example of a dual-side transistor chip package in transparent contour illustration, wherein the G1 and G2 domains are highlighted by hatching.
Figure 11A is a side perspective view of the third example of a dual-side transistor chip package including a heat sink.
Figure 11B is a bottom perspective view of the third example of a dual-side transistor chip package including a heat sink.
Figure 11C is a side views from viewing direction V2 of the third example of a dual-side transistor chip package including a heat sink.
Figure 12 is a side perspective view illustrating the third example of a dual-side transistor chip package of Figures 8A to 9D without mold compound attached to an application board in vertical orientation relative to the application board.
Figure 13 is a side view of an example of a dual-side transistor chip package including a passive element atop the transistor chips.
Figure 14 is a side view of an example of a dual-side transistor chip package including a passive element beneath the transistor chips.

### Detailed description

As used in this specification, the terms "electrically connected" or "electrically coupled" or similar terms are not meant to mean that the elements are directly contacted together; intervening elements may be provided between the "electrically connected" or "electrically coupled" elements, respectively. However, in accordance with the disclosure, the above-mentioned and similar terms may, optionally, also have the specific meaning that the elements are directly contacted together, i.e. that no intervening elements are provided between the "electrically connected" or "electrically coupled" elements, respectively.

Further, the words "over" or "beneath" or similar terms with regard to a part, element or material layer formed or located or arranged "over" or "beneath" a surface may be used herein to mean that the part, element or material layer be located (e.g. placed, formed, arranged, deposited, etc.) "directly on" or "directly under", e.g. in direct contact with, the implied surface. The word "over" or "beneath" or similar terms used with regard to a part, element or material layer formed or located or arranged "over" or "beneath" a surface may, however, either be used herein to mean that the part, element or material layer be located (e.g. placed, formed, arranged, deposited, etc.) "indirectly on" or "indirectly under" the implied surface, with one or more additional parts, elements or layers being arranged between the implied surface and the part, element or material layer.

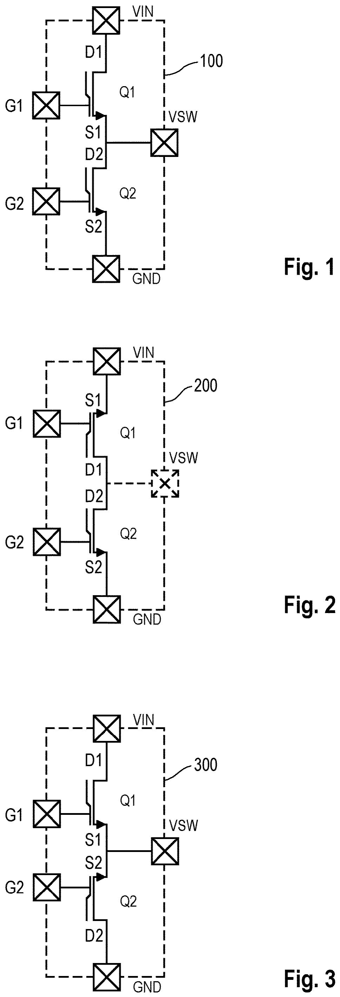

Referring to Figures 1 to 3, examples of semiconductor packages 100, 200 and 300 are described. Each semiconductor package 100, 200, 300 includes a first transistor chip Q1 and a second transistor chip Q2. The first transistor chip Q1 and the second transistor chip Q2 are connected in series.

Each semiconductor package 100, 200, 300 includes a ground terminal GND, an operational voltage terminal VIN, a first gate terminal G1 and a second gate terminal G2. Further, semiconductor packages 100 to 300 may include a switch terminal VSW. For semiconductor package 200 the switch terminal VSW may be omitted.

More specifically, the ground terminal GND may be connected to ground, i.e. to zero voltage or a specific reference voltage. The operational voltage terminal VIN may be connected to an operational voltage, e.g. more than 50V or 100V or 200V or 300V or 400V or 500V or 700V or 900V or 1000V. The first gate terminal G1 may be connected to a first gate driver (not shown) and the second gate terminal G2 may be connected to a second gate driver (not shown). The switch terminal VSW may be connected to a load (not shown).

All these connections described above may, e.g., be external connections, e.g. connections between external components mounted, e.g., on an application board on which the semiconductor package 100, 200, 300 is mounted and the corresponding terminals of the semiconductor package 100, 200, 300. However, in other examples, it is also possible that one or more of the gate drivers (not shown) are included in the semiconductor package 100, 200, 300.

More specifically, in Figures 1 to 3 the drain and the source of the first transistor chip Q1 are denoted by D1 and S1 respectively, and the drain and the source of the second transistor chip Q2 are denoted by D2 and S2, respectively. In the semiconductor package 100, D1 is connected to VIN, S1 is connected to D2 and S2 is connected to GND. This circuit diagram is also referred to as a D1-S1-D2-S2 configuration.

In semiconductor package 200, S1 is connected to VIN, D1 is connected D2 and S2 is connected to GND. This circuit diagram will also be referred to as S1-D1-D2-S2 configuration in the following.

In Figure 3 showing semiconductor package 300, D1 is connected to VIN, S1 is connected to S2 and D2 is connected to GND. This circuit diagram will also be denoted as D1-S1-S2-D2 in the following.

In all packages 100 to 300, the switch terminal VSW is connected to a node arranged between the first transistor chip Q1 and the second transistor chip Q2.

As apparent for a person skilled in the art, the semiconductor package 100 includes a half bridge circuitry. The first transistor chip Q1 provides the high side switch (HSS) and the second transistor chip Q2 provides the low side switch (LSS). A half bridge circuitry may be capable of switching large currents, wherein the switched current is available at the terminal VSW (which is configured to be connected to the external load).

In the following, various examples are provided for implementing power circuitry including at least two transistor chips Q1, Q2 in a semiconductor package. All examples described herein are based on the concept to use the third dimension (perpendicular or inclined to an application board) for reducing the footprint area of the semiconductor package, i.e. the area consumption of the semiconductor package on the application board. In many applications, this third dimension is available due to the fact that there are other components mounted on the application board which may be taller than the semiconductor chips Q1, Q2.

In other words, as will be explained in more detail further below, the first and second semiconductor chips Q1 and Q2 are mounted on a chip carrier which is configured to electrically connect the first transistor chip Q1 and the second transistor chip Q2 serially and which is configured to be attached to an application board in inclined, in particular vertical orientation relative to the application board. That way, the area consumption on an application board (e.g., a printed circuit board (PCB)) may be reduced by about 700.

Further, the electrical parasitic may be reduced by a reduction of the stray inductance and the stray resistance between an input capacitor and first transistor chip Q1 (e.g., HSS) and the second transistor chip Q2 (e.g., LSS). The reduction of the stray inductance may be about 30% and the reduction of the stray resistance may be about 10% compared with horizontal packages (in which a chip carrier is oriented parallel to the application board).

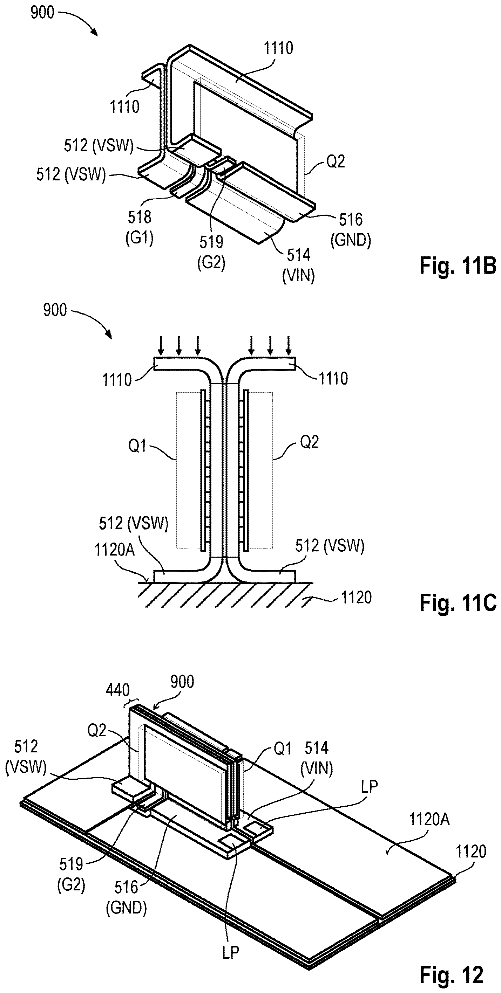

Reduction of stray inductance is especially important for devices (e.g., converters) with operation frequencies of 2 MHz and higher. This second level improvement reflects also in the power density. A lower stray inductance allows higher switching frequency due to the lower switching losses and, as secondary effect, a reduction of the size of passive components (see, e.g., Figures 12 to 14) used to build the devices.

The reduction of stray resistance of the semiconductor package is in general relevant to increase the power density of the package.

Further, as will also be described in more detail further below, it is possible to reuse existing packaging technologies in view of mounting the first transistor chip Q1 and the second transistor chip Q2 on the chip carrier. More specifically, a leadframe concept may be used for the chip carrier and the first semiconductor chip Q1 and the second semiconductor chip Q2 may be connected to leadframes similarly as in conventional horizontal semiconductor packages.

In the following, semiconductor packages according to the disclosure including at least a first transistor chip Q1 and a second transistor chip Q2, wherein the first transistor chip Q1 and the second transistor chip Q2 are mounted on opposite sides of a chip carrier. Such semiconductor packages are also referred to as dual-side transistor chip packages.

For purpose of explanation, the following examples of dual-side transistor chip packages use the circuit diagram of Figure 1. That is, the examples of dual-side transistor chip packages described below implement a D1-S1-D2-S2 configuration as, e.g., used in a half bridge circuitry. However, it is to be noted that semiconductor packages 200, 300, using a S1-D1-D2-S2 configuration and a D1-S1-S2-D2 configuration, may be implemented in an analogous manner. Thus, features disclosed in the following description in the context of a specific example can be applied to all semiconductor packages described herein if not stated otherwise or excluded on technical grounds.

The transistor chips Q1, Q2 may be lateral semiconductor devices, meaning that the transistor chips Q1, Q2 are configured to conduct a load current mainly in a direction parallel to a main surface of the respective transistor chip Q1, Q2. Lateral transistor chips Q1, Q2 may have bond pads (only) at one main surface of the transistor chip Q1, Q2.

As an example, each transistor chip Q1, Q2 may be a GaN power transistor chip, in particular a GaN HEMT (high electron mobility transistor). In this and other examples the power transistor chip Q1, Q2 may have at least one source chip pad, at least one drain chip pad and a gate chip pad at the one main surface.

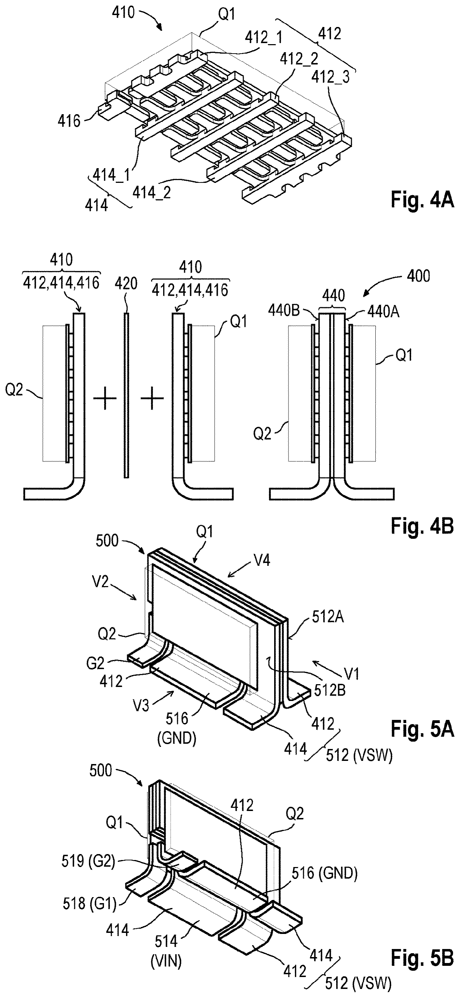

Figure 4A illustrates a transistor chip (e.g., first transistor chip Q1) mounted on a leadframe 410.

The leadframe 410 may include a plurality of leadframe sections. A first leadframe section 412 may, e.g., include one or a plurality of first leadframe segment(s) 412_1, 412_2, 412_3.

The leadframe 410 may further include a second leadframe section 414. The second leadframe section 414 may, e.g., include one or a plurality of second leadframe segment(s) 414_1, 414_2.

The leadframe 410 may further include a third leadframe section 416.

The first leadframe section 412 may be connected to source chip pads (not shown) of the first transistor chip Q1. The second leadframe section 414 may be connected to drain chip pads (not shown) of the first transistor chip Q1. The third leadframe section 416 may be connected to a gate chip pad (not shown) of the first transistor chip Q1.

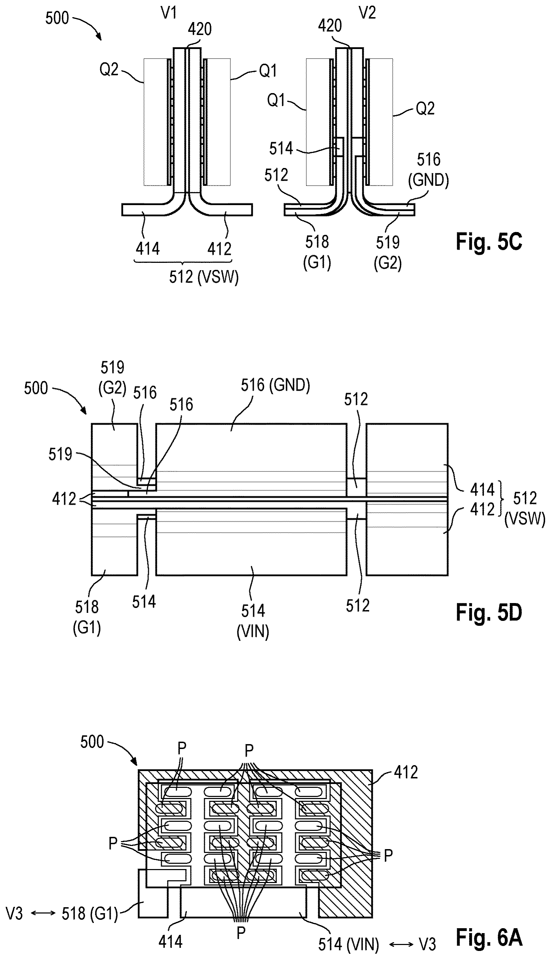

As known in the art, the source chip pads and the drain chip pads of the first transistor chip Q1 may be arranged in a comb-like design with interdigitated drain and source pads (see, e.g., Figures 6A to 6C, 8A to 8C, 10A to 10C). Therefore, the first leadframe section 412 (connected to the source chip pads) and the second leadframe section 414 (connected to the drain chip pads) may be segmented, for example. Further, the first leadframe segment(s) 412_1, 412_2, 412_3 and the second leadframe segment(s) 414_1, 414_2 may include arms which are perpendicular to the longitudinal extension of the respective segment(s). The arms of the first leadframe segment(s) 412_1, 412_2, 412_3 and the arms of the second leadframe segment(s) 414_1, 414_2 may, e.g., be interdigitated.

In other examples (not shown), the source chip pads and the drain chip pads may, e.g., be designed as stripes. In this case, the first leadframe section 412 and/or the second leadframe section 414 may not need to be segmented, i.e. may be designed in a stripe-shaped design in correspondence with the stripe-shaped design of the corresponding chip pads.

Figure 4B illustrates the concept of combining a first transistor chip Q1 and a second transistor chip Q2 in a semiconductor package 400. The first transistor chip Q1 may be mounted on first, second and third leadframe sections 412, 414, 416 as, e.g., shown in Figure 4A. Similarly, the second transistor chip Q2 may be mounted on first, second and third leadframe sections 412, 414, 416 as, e.g., shown in Figure 4A.

For example, a bond structure 420 may be used to connect the leadframe sections 412, 414, 416 on which the first and second transistor chips Q1, Q2 are mounted. The bond structure 420 may include segments (not visible in Figure 4B) which are made of an electrically conductive material such as, e.g. solder, conductive adhesive, metal paste, or diffusion solder material. In addition, the bond structure 420 may include segments (not visible in Figure 4B) which are made of an electrically insulating material such as, e.g. a laminate, a glue, etc.

Depending on the circuit diagram (e.g. Figures 1 to 3), the bond structure 420 electrically connects or electrically disconnects (insulates) the first leadframe section 412 and/or the second leadframe section 414 on which the first transistor chip Q1 is mounted to or from the first leadframe section 412 and/or the second leadframe section 414 on which the second transistor chip Q2 is mounted. In addition, the bond structure 420 electrically disconnects (insulates) the third leadframe section 416 connected to the gate chip pad of the first transistor chip Q1 from the third leadframe section 416 connected to the gate chip pad of the second transistor chip Q2.

In other words, the first transistor chip Q1 and the second transistor chip Q2 are mounted on a chip carrier 440 which may provide the transistor chip wiring in accordance with the circuit diagrams of Figures 1 to 3. In general, the chip carrier 440 may but does not need to be formed by different leadframes which are connected and held together by a bond structure 420 as shown in Figure 4B. Rather, the first transistor chip Q1 and the second transistor chip Q2 may be mounted to a chip carrier 440 having a first main side 440A and a second main side 440B opposite the first main side 440A. The first main side 440A faces the first transistor chip Q1 (more specifically, a first side of the first transistor chip Q1 which comprises at least one source chip pad and at least one drain chip pad) and is attached to the at least one source chip pad and the at least one drain chip pad of the first transistor chip Q1. The second main side 440B of the chip carrier 440 faces the second transistor chip Q2 (more specifically, a first side of the second transistor chip Q2 which includes at least one source chip pad and at least one drain chip pad) and is attached to the at least one source chip pad and the at least one drain chip pad of the second transistor chip Q2. The chip carrier 440 may, e.g., include one or more leadframes (as shown in the examples presented herein). In other examples (not shown), the chip carrier 440 may, e.g., include a PCB or a ceramic-based carrier, for example.

Figures 5A to 5D illustrates a first example of a semiconductor package 500, which is a dual-side transistor chip package. The chip carrier 440 includes a first leadframe structure 512, wherein the first transistor chip Q1 is attached to a first main side 512A of the first leadframe structure 512, and the second transistor chip Q2 is attached to a second main side 512B of the first leadframe structure 512. As described above, the first leadframe structure 512 may be composed of two leadframes section 412 and 412 or 412 and 414 or 414 and 414, wherein on each leadframe section 412 and/or 414 one of the transistor chips Q1, Q2 is mounted.

For example, referring to the circuit diagram of Figure 1, the first leadframe section 412 (and thus, e.g., the segments 412_1, 412_2, 412_3 thereof) is connected to the source pads of the first transistor chip Q1, the second leadframe section 414 (and thus, e.g., the segments 414_1, 414_2) is connected to the drain pads of the second transistor chip Q2, and the first leadframe structure 512 is formed by the combined first and second leadframe sections 412 and 414. The first leadframe structure 512 may form a first terminal (e.g., switch terminal VSW) of the semiconductor package 500.

The chip carrier 440 may further include a second leadframe structure 514. The first transistor chip Q1 is attached to the second leadframe structure 514. For example, referring to the circuit diagram of Figure 1, the second leadframe structure 514 may include or be formed of the second leadframe section 414 (including, e.g., the second leadframe segments 414_1, 414_2) connected to the first transistor chip Q1. The second leadframe structure 514 may form a second terminal (e.g., VIN terminal) of the semiconductor package 500.

The chip carrier 440 may further include a third leadframe structure 516. For example, referring to the circuit diagram of Figure 1, the third leadframe structure 516 may, e.g., be implemented by a first leadframe section 412 on which the second transistor chip Q2 is mounted. The third leadframe structure 516 may form a third terminal (e.g., ground terminal GND) of the semiconductor package 500.

Further, the semiconductor package 500 may include a fourth leadframe structure 518 forming a first gate terminal G1 and/or a fifth leadframe structure 519 forming a second gate terminal G2 of the semiconductor package 500. The gate terminal G1 corresponds to leadframe section 416 of Figures 4A to 4C.

Figure 5D illustrates a bottom view (footprint) of the semiconductor package 500. The second leadframe structure 514 (e.g. terminal VIN) may be arranged between the fourth leadframe structure 518 (e.g. first gate terminal G1) and the first leadframe structure 512 (e.g. switch terminal VSW). The third leadframe structure 516 (e.g. ground terminal GND) may be arranged between the fifth leadframe structure 519 (second gate terminal G2) and the first leadframe structure 512 (e.g. switch terminal VSW).

End portions of the first leadframe structure 512 and/or the second leadframe structure 514 and/or the third leadframe structure 516 and/or the fourth leadframe structure 518 and/or the fifth leadframe structure 519 may be bent out of a plane given by the first main side or the second main side of the chip carrier 440. In other words, the semiconductor package terminals may be bent in a direction parallel to an application board (not shown) on which the semiconductor package 500 is to be mounted. The bent portions of the leadframe structures 512, 514, 516, 518, 519 allow to increase the contact area of the semiconductor package 500 to an application board (not shown). Further, the bent portions mechanically stabilize the semiconductor package 500 during an attachment process (e.g. soldering) of the semiconductor package 500 to the application board.

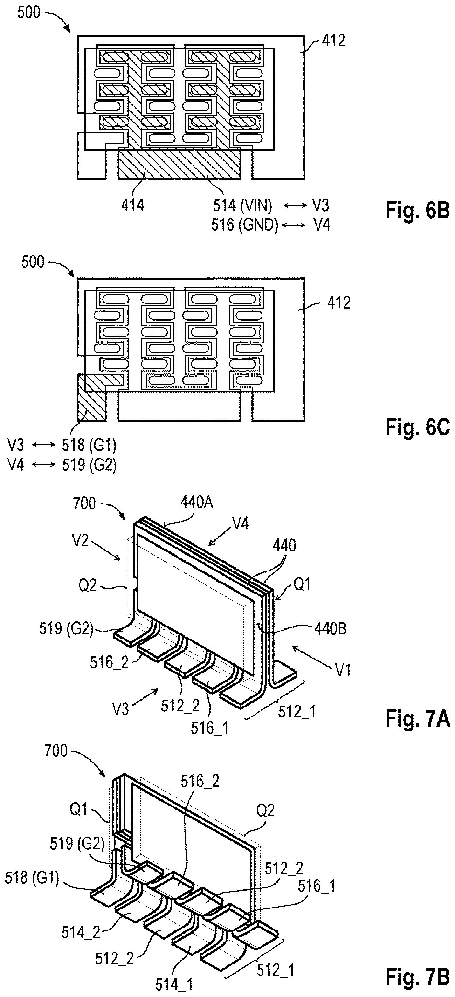

Referring to Figures 6A to 6C representing a plan view from direction V3 on the transistor chip package 500 shown in Figure 5A, chip pads P located on a side of the first transistor chip Q1 facing the first main side 440A of the chip carrier 440 (see Figure 4B) are connected to the corresponding segments of the leadframe sections 412, 414, 416. More specifically, the first leadframe section 412, representing the VSW domain, is connected to the source chip pads P of the first transistor chip Q1 and is highlighted by hatching in Figure 6A. The drain chip pads of the first transistor chip Q1 are connected to the second leadframe structure 514 (VIN), wherein the VIN domain is highlighted by hatching in Figure 6B. The gate chip pad of the firs transistor chip Q1 is connected to the fifth leadframe structure 519 forming the first gate terminal G1. In Figure 6C, the G1 domain is highlighted by hatching.

Figures 6A to 6C may also apply to a plan view of the dual-side transistor chip package 500 from direction V4 (see Figure 5A). From viewing direction V4, the chip pads P shown are the chip pads of the second transistor chip Q2. The VSW domain (second leadframe section 414 of the first leadframe structure 512) is highlighted by hatching in Figure 6A, the GND domain (third leadframe structure 516) is highlighted by hatching in Figure 6B and the G2 domain (fifth leadframe structure 519) is highlighted in Figure 6C by hatching.

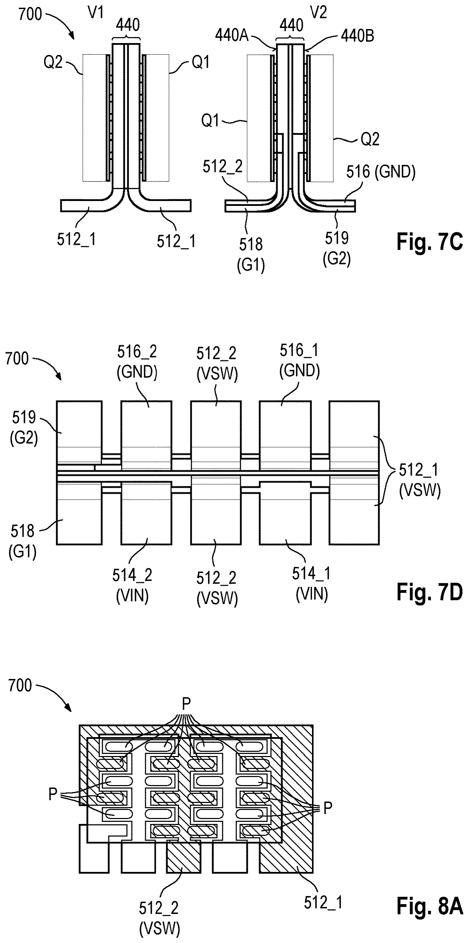

Figures 7A to 7D show a second example of a semiconductor package 700, which is a dual-side transistor chip package. Similar as in semiconductor package 500, the semiconductor package 700 may implement all circuit diagrams of semiconductor packages 100, 200 and 300, for example. In the following, without loss of generality and for purpose of explanation only, semiconductor package 700 implements the half bridge circuitry of semiconductor package 100.

Semiconductor package 700 may be identical with Semiconductor package 500 except that the design of the package terminals is modified. Here, the first leadframe structure 512 includes end portions bent out of a plane given by the first main side 440A or the second main side 440B of the chip carrier 440 to form first terminals 512_1 of the first leadframe structure and end portions bent out of the plane given by the first main side 440A or the second main side 440B of the chip carrier 440 to form second terminals 512_2 of the first leadframe structure 512.

In other words, the semiconductor package 700 may include four VSW terminals, namely first terminals 512_1 and second terminals 512_2 of the first leadframe structure 512 at each side of the semiconductor package 700.

The second leadframe structure 514 includes a first terminal 514_1 and a second terminal 514_2. These terminals are arranged at the side of the semiconductor package 700 at which the first transistor chip Q1 is mounted. The first and second terminals 514_1, 514_2 may represent VIN terminals.

Further, the third leadframe structure 516 may include a first terminal 516_1 and a second terminal 516_2. The first and second terminals 516_1 and 516_2 of the third leadframe structure 516 may be arranged at a side of the semiconductor package 700 where the second transistor chip Q2 is mounted.

The fourth and fifth leadframe structures 518, 519 forming the first and second gate terminals G1, G2 of the semiconductor package 700 are arranged the same way as in semiconductor package 500.

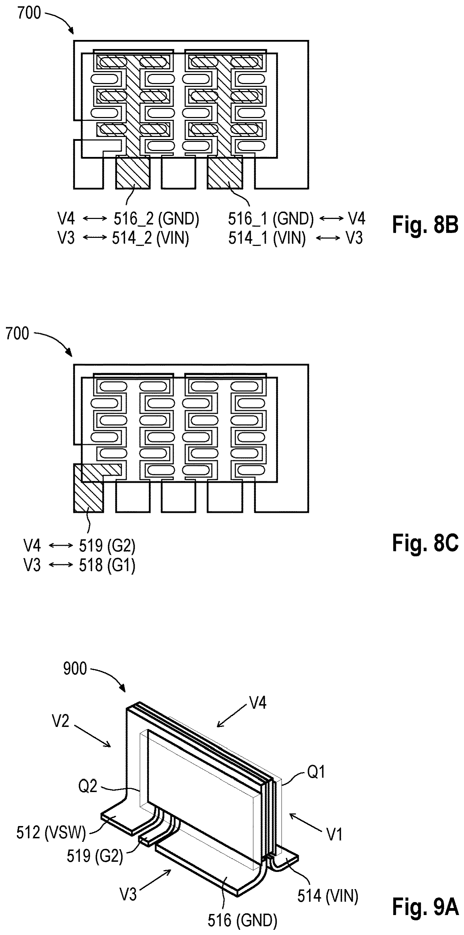

Figures 8A to 8C illustrate transparent contour line side views of the semiconductor package 700 as described before with reference to Figures 6A to 6C. Briefly, in Figure 8A the VSW domain is highlighted by hatching, in Figure 8B the VIN domain (for viewing direction V3) or the GND domain (for viewing direction V4) are highlighted by hatching and in Figure 8C, the G1 domain (for viewing direction V3) or the G2 domain (for viewing direction V4) are highlighted by hatching.

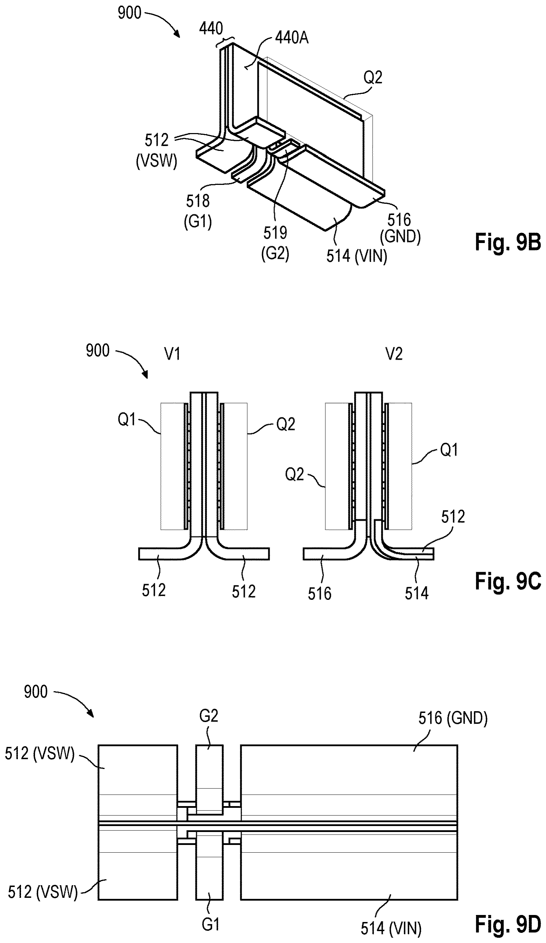

Figures 9A to 9B illustrates a third example of a semiconductor package 900 which is a dual-side transistor chip package. The semiconductor package 900 is similar to the semiconductor packages 500 and 700, and reference is made to the description above to avoid reiteration.

In semiconductor package 900, bent-out end portions of the first leadframe structure 512 form first terminals (e.g. VSW terminals), a bent-out portion of the second leadframe structure 514 forms a second terminal (e.g., VIN terminal) and a bent-out portion of the third leadframe structure 516 forms a third terminal (e.g., GND terminal) of the semiconductor package 900. Further, a fourth leadframe structure 518 and a fifth leadframe structure 519 are forming a fourth and a fifth terminals (e.g., G1 and G2), respectively.

In this example the fourth leadframe structure 518 forming the first gate terminal G1 is arranged between the first leadframe structure 512 (e.g. VSW terminal) and the second leadframe structure 514 (e.g. VIN terminal). Alternatively or in combination, the fourth leadframe structure 519 forming, e.g., the second gate terminal G2 is arranged between the first leadframe structure 512 (e.g. VSW terminal) and the third leadframe structure 516 (e.g. GND terminal).

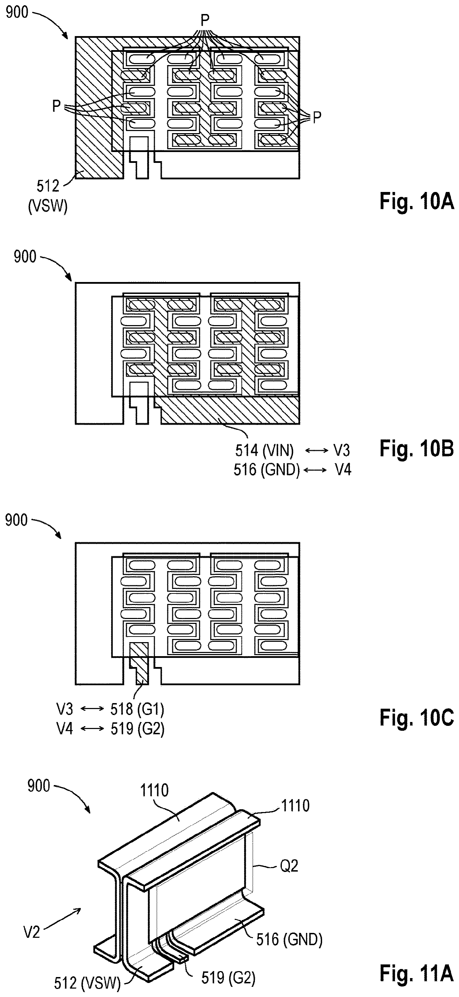

For semiconductor package 900, the VSW domain formed by the first leadframe structures 512 is highlighted by hatching in Figure 10A. The VIN domain formed by the second leadframe structure 514 or the GND domain formed by the third leadframe structure 516 are highlighted by hatching in Figure 10B. The gate domains formed by the fourth leadframe structure 518 (first gate terminal G1) and the fifth leadframe structure 519 (second gate terminal G2) are highlighted by hatching in Figure 10C. Reference is made to the description of Figures 6A to 6C and 8A to 8C to avoid reiteration.

The various examples of semiconductor packages 500, 700 and 900 may be designed to include the following features:

The first terminal VSW, the second terminal VIN, the third terminal GND, the fourth terminal G1 and the fifth terminal G2 may be formed by one or more end portions of the first leadframe structure 512, the second leadframe structure 514, the third leadframe structure 516, the fourth leadframe structure 518 and the fifth leadframe structure 519 bent out of a plane given by the first main side or the second main side of the chip carrier. The bent-out end portion(s) may be arranged in a footprint array, see Figures 5D, 7D, 9D.

In general, in such footprint array, an order of the first terminal denoted by T1 (e.g., VSW), the second terminal denoted by T2 (e.g., VIN), the third terminal denoted by T3 (e.g., GND), the fourth terminal denoted by T4 (e.g., G1) and the fourth terminal denoted by T5 (e.g., G2), in a direction parallel to a plane given by the first main side or the second main side of the chip carrier, may be as follows:
T1, offset to T2 and T3, offset to T4 and T5, see e.g. semiconductor package 500.
A first part of T1, offset to a first part of T2 and a first part of T3, offset to a second part of T1, offset to a second part of T2 and a second part of T3, offset to T4 and T5, see e.g. semiconductor package 700.
T2 and T3, offset to T4 and T5, offset to T1, see e.g. semiconductor package 900.

The various examples of semiconductor packages 500, 700 and 900 provide the following benefits:

Semiconductor package 500 has the simplest construction in terms of the chip carrier 440. The benefit of semiconductor package 700 is the lower electrical and thermal resistance to the application board, since the current is spread through a larger number of terminals. In semiconductor package 900, the VIN terminal and the GND terminal are available at a lateral side of the package, allowing an easy integration of a passive element (e.g., capacitor) connecting to these terminals. Further, the stray inductance is reduced by this package concept.

All semiconductor packages 100 to 500, 700, 900 may be provided with a heat sink. Referring to Figure 11A, a heat sink 1110 may be disposed at an upper side of the semiconductor package. For purpose of explanation, semiconductor package 900 is used as an example, however, all packages described herein may be provided with a heat sink 1110.

The heat sink 1110 may be connected or be an integral part of the first leadframe structure 512. As shown in Figure 11A, the heat sink 1110 may, e.g., be formed by bent-out end portions of the first leadframe structure 512. Here, two bent-out portions of the first leadframe structure 512 are used. In other examples, in which the first leadframe structure 512 is, e.g., formed by a single (integral) leadframe, a single bent-out end portion of this first leadframe structure 512 may be used as a heat sink 1110.

Figure 11C is side view from viewing direction V2 (see Figure 11A). In Figure 11C a surface of the application board 1120 is indicated by reference sign 1120A. Further, Figure 11C schematically illustrates by arrows directed to the heat sink 1110 that the heat sink 1110 may be connected to further thermally conductive means to improve thermal dissipation.

Figure 12 illustrates the semiconductor package 900 when mounted on the application board 1120. Further, the semiconductor package 900 may be provided with a capacitor (not shown) mounted laterally aside the first transistor chip Q1 and the second transistor chip Q2 on the second leadframe structure 514 (e.g. VIN terminal) and the third leadframe structure 516 (e.g. GND terminal).

More specifically, Figure 12 illustrates leadframe pads LP disposed on these leadframe structures 514, 516. These leadframe pads LP may form an integral part of the semiconductor package 900 but may be located outside of an encapsulation or mold compound body (not shown) used for encapsulating the transistor chips Q1 and Q2. In this case, the semiconductor package 900 (with or without heat sink 1110, as shown in Figures 9A to 9D or 11A to 11C) is provided with a specific mounting place configured for adding a capacitor (not shown) to the semiconductor package 900. That way, the capacitor does not need to be mounted as an external capacitor on the application board 1120, but can be mounted on the semiconductor package 900.

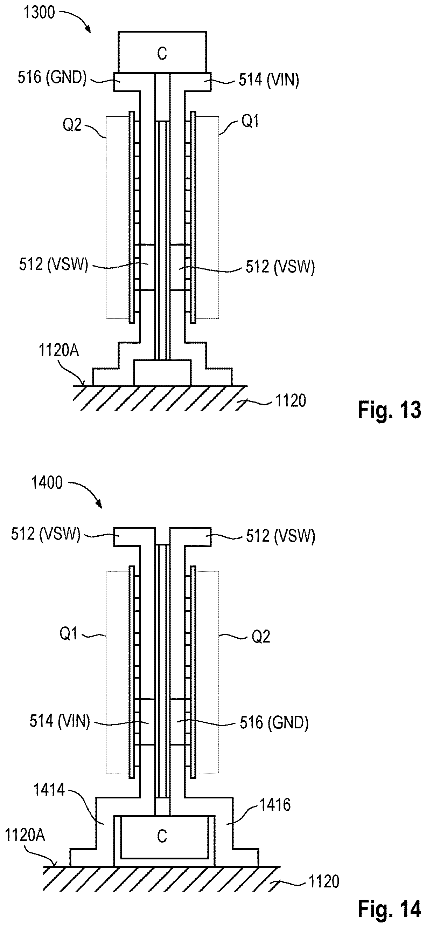

Figures 13 and 14 are side views of semiconductor packages 1300 and 1400 illustrating further examples of including a passive element (e.g., a capacitor C) in the package. In Figure 13 the capacitor C is mounted vertically atop the first transistor chip Q1 and the second transistor chip Q2. More specifically, the second leadframe structure 514 and the third leadframe structure 516 may have bent-out end portions at the top of the semiconductor package 1300, on which the capacitor C is mounted.

Referring to Figure 14, the capacitor C may be mounted vertically beneath the first transistor chip Q1 and the second transistor chip Q2. In this example, the second leadframe structure 514 may be connected to a lead 1414 and the third leadframe structure 516 may be connected to a lead 1416. The leads 1414, 1416 may electrically connect to electrodes of the capacitor C. For example, the leads 1414, 1416 may have a stepped shape allowing the capacitor C to be mounted beneath a stepped portion of the leads 1414, 1416 and the surface 1120A of the application board 1120.

### EXAMPLES

The following examples pertain to further aspects of the disclosure:
Example 1 is a semiconductor package comprising a first transistor chip having a first side and a second side opposite the first side. The first side comprises at least one source chip pad, S1, and at least one drain chip pad, D1. The semiconductor package further comprises a second transistor chip having a first side and a second side opposite the first side, wherein the first side comprises at least one source chip pad, S2, and at least one drain chip pad, D2. A chip carrier has a first main side and a second main side opposite the first main side, wherein the first main side of the chip carrier faces the first side of the first transistor chip and is attached to the at least one source chip pad, S1, and the at least one drain chip pad, D1, of the first transistor chip, and the second main side of the chip carrier faces the first side of the second transistor chip and is attached to the at least one source chip pad, S2, and the at least one drain chip pad, D2, of the second transistor chip. The chip carrier is configured to electrically connect the first transistor chip and the second transistor chip serially in a D1-S1-D2-S2 configuration or in a S1-D1-D2-S2 configuration or in a D1-S1-S2-D2 configuration. In addition, chip carrier is configured to be attached to an application board in inclined, in particular vertical orientation relative to the application board.
In Example 2, the subject matter of Example 1 can optionally include wherein the chip carrier comprises a first leadframe structure, wherein the first transistor chip is attached to a first main side of the first leadframe structure and the second transistor chip is attached to a second main side of the first leadframe structure.
In Example 3, the subject matter of Example 2 can optionally include wherein an end portion of the first leadframe structure is bent out of a plane given by the first main side or the second main side of the chip carrier to form a first terminal of the semiconductor package.
In Example 4, the subject matter of Example 3 can optionally include wherein in configuration D1-S1-D2-S2, the at least one chip pad S1 and the at least one chip pad D2 are attached to the first leadframe structure, or in configuration S1-D1-D2-S2, the at least one chip pad D1 and at least one chip pad D2 are attached to the first leadframe structure, or in configuration D1-S1-S2-D2, the at least one chip pad S1 and the at least one chip pad S2 are attached to the first leadframe structure.
In Example 5, the subject matter of any of the preceding Examples can optionally include wherein the chip carrier comprises a second leadframe structure, wherein the first transistor chip is attached to the second leadframe structure, and wherein an end portion of the second leadframe structure is bent out of a plane given by the first main side or the second main side of the chip carrier to form a second terminal of the semiconductor package.
In Example 6, the subject matter of Example 5 can optionally include wherein in configuration D1-S1-D2-S2, the at least one chip pad D1 is attached to the second leadframe structure, or in configuration S1-D1-D2-S2, the at least one chip pad S1 is attached to the second leadframe structure, or in configuration D1-S1-S2-D2, the at least one chip pad D1 is attached to the second leadframe structure.
In Example 7, the subject matter of any of the preceding Examples can optionally include wherein a drain segment is disposed between a first source segment and a second source segment, and a source bridge segment connects the first source segment and the second source segment, or a source segment is disposed between a first drain segment and a second drain segment, and a drain bridge segment connects the first drain segment and the second drain segment.
In Example 8, the subject matter of Example 7 can optionally include wherein the chip carrier comprises a third leadframe structure, wherein the second transistor chip is attached to the third leadframe structure, and wherein an end portion of the third leadframe structure is bent out of a plane given by the first main side or the second main side of the chip carrier to form a third terminal of the semiconductor package.
In Example 9, the subject matter of any of the preceding Examples can optionally include wherein the chip carrier comprises a fourth leadframe structure which is connected to a gate pad, G1, of the first transistor chip and a fifth leadframe structure which is connected to a gate pad, G2, of the second transistor chip.
In Example 10, the subject matter of Examples 3 or 4 and Examples 5 or 6 and Examples 7 or 8 and Example 9 can optionally include wherein the first terminal, the second terminal, the third terminal, a fourth terminal which is formed by an end portion of the fourth leadframe structure bent out of a plane given by the first main side or the second main side of the chip carrier, and a fifth terminal which is formed by an end portion of the fifth leadframe structure bent out of a plane given by the first main side or the second main side of the chip carrier, are arranged in a footprint array.
In Example 11, the subject matter of Example 10 can optionally include wherein, in the footprint array, an order of the first terminal denoted by T1, the second terminal denoted by T2, the third terminal denoted by T3, the fourth terminal denoted by T4 and the fourth terminal denoted by T5 is, in a direction parallel to a plane given by the first main side or the second main side of the chip carrier, T1, offset to T2 and T3, offset to T4 and T5, or a first part of T1, offset to a first part of T2 and a first part of T3, offset to a second part of T1, offset to a second part of T2 and a second part of T3, offset to T4 and T5, or T2 and T3, offset to T4 and T5, offset to T1.
In Example 12, the subject matter Examples 5 and 7 can optionally include a capacitor connected to the second leadframe structure and the third leadframe structure.
In Example 13, the subject matter of Example 12 can optionally include wherein the capacitor is mounted laterally aside the first transistor chip and the second transistor chip on the first terminal and the second terminal.
In Example 14, the subject matter of Example 12 can optionally include wherein the capacitor is mounted vertically atop the first transistor chip and the second transistor chip.
In Example 15, the subject matter of Example 12 can optionally include wherein the capacitor is mounted vertically beneath the first transistor chip and the second transistor chip.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor package, comprising:
a first transistor chip having a first side and a second side opposite the first side, wherein the first side comprises at least one source chip pad, S1, and at least one drain chip pad, D1;
a second transistor chip having a first side and a second side opposite the first side, wherein the first side comprises at least one source chip pad, S2, and at least one drain chip pad, D2; and
a chip carrier having a first main side and a second main side opposite the first main side, wherein the first main side of the chip carrier faces the first side of the first transistor chip and is attached to the at least one source chip pad, S1, and the at least one drain chip pad, D1, of the first transistor chip, and the second main side of the chip carrier faces the first side of the second transistor chip and is attached to the at least one source chip pad, S2, and the at least one drain chip pad, D2, of the second transistor chip;
wherein the chip carrier is configured
to electrically connect the first transistor chip and the second transistor chip serially in a D1-S1-D2-S2 configuration or in a S1-D1-D2-S2 configuration or in a D1-S1-S2-D2 configuration, and
to be attached to an application board in inclined, in particular vertical orientation relative to the application board.

2. The semiconductor package of claim 1, wherein the chip carrier comprises a first leadframe structure, wherein the first transistor chip is attached to a first main side of the first leadframe structure and the second transistor chip is attached to a second main side of the first leadframe structure.

3. The semiconductor package of claim 2, wherein an end portion of the first leadframe structure is bent out of a plane given by the first main side or the second main side of the chip carrier to form a first terminal of the semiconductor package.

4. The semiconductor package of claim 3, wherein
in configuration D1-S1-D2-S2, the at least one chip pad S1 and the at least one chip pad D2 are attached to the first leadframe structure, or
in configuration S1-D1-D2-S2, the at least one chip pad D1 and at least one chip pad D2 are attached to the first leadframe structure, or
in configuration D1-S1-S2-D2, the at least one chip pad S1 and the at least one chip pad S2 are attached to the first leadframe structure.

5. The semiconductor package of any of the preceding claims, wherein the chip carrier comprises a second leadframe structure, wherein the first transistor chip is attached to the second leadframe structure, and wherein an end portion of the second leadframe structure is bent out of a plane given by the first main side or the second main side of the chip carrier to form a second terminal of the semiconductor package.

6. The semiconductor package of claim 5, wherein
in configuration D1-S1-D2-S2, the at least one chip pad D1 is attached to the second leadframe structure, or
in configuration S1-D1-D2-S2, the at least one chip pad S1 is attached to the second leadframe structure, or
in configuration D1-S1-S2-D2, the at least one chip pad D1 is attached to the second leadframe structure.

7. The semiconductor package of any of the preceding claims, wherein the chip carrier comprises a third leadframe structure, wherein the second transistor chip is attached to the third leadframe structure, and wherein an end portion of the third leadframe structure is bent out of a plane given by the first main side or the second main side of the chip carrier to form a third terminal of the semiconductor package.

8. The semiconductor package of claim 7, wherein
in configuration D1-S1-D2-S2, the at least one chip pad S2 is attached to the third leadframe structure, or
in configuration S1-D1-D2-S2, the at least one chip pad S2 is attached to the third leadframe structure, or
in configuration D1-S1-S2-D2, the at least one chip pad D2 is attached to the third leadframe structure.

9. The semiconductor package of any of the preceding claims, wherein the chip carrier comprises
a fourth leadframe structure which is connected to a gate pad, G1, of the first transistor chip and
a fifth leadframe structure which is connected to a gate pad, G2, of the second transistor chip.

10. The semiconductor package of claim 3 or 4 and claim 5 or 6 and claim 7 or 8 and claim 9, wherein the first terminal, the second terminal, the third terminal, a fourth terminal which is formed by an end portion of the fourth leadframe structure bent out of a plane given by the first main side or the second main side of the chip carrier, and a fifth terminal which is formed by an end portion of the fifth leadframe structure bent out of a plane given by the first main side or the second main side of the chip carrier, are arranged in a footprint array.

11. The semiconductor package of claim 10, wherein, in the footprint array, an order of the first terminal denoted by T1, the second terminal denoted by T2, the third terminal denoted by T3, the fourth terminal denoted by T4 and the fourth terminal denoted by T5 is, in a direction parallel to a plane given by the first main side or the second main side of the chip carrier,
T1, offset to T2 and T3, offset to T4 and T5, or
a first part of T1, offset to a first part of T2 and a first part of T3, offset to a second part of T1, offset to a second part of T2 and a second part of T3, offset to T4 and T5, or
T2 and T3, offset to T4 and T5, offset to T1.

12. The semiconductor package of claim 5 and claim 7, further comprising:
a capacitor connected to the second leadframe structure and the third leadframe structure.

13. The semiconductor package of claim 12, wherein the capacitor is mounted laterally aside the first transistor chip and the second transistor chip on the first terminal and the second terminal.

14. The semiconductor package of claim 12, wherein the capacitor is mounted vertically atop the first transistor chip and the second transistor chip.

15. The semiconductor package of claim 12, wherein the capacitor is mounted vertically beneath the first transistor chip and the second transistor chip.
